# EUROPEAN PATENT SPECIFICATION

(11) **EP 3 054 032 B1**
(45) Date of publication and mention of the grant of the patent: **23.08.2017**
(21) Application number: 15154257.8
(22) Date of filing: 09.02.2015
(51) Int. Cl.: C23C 16/54, C23C 16/50, C23C 16/455, B01J 3/00, H01J 37/32, C23C 16/44

(54) **Installation for film deposition onto and/or modification of the surface of a moving substrate**
Installation zur Filmabscheidung auf und/oder zur Modifikation der Oberfläche eines sich bewegenden Substrats
Installation pour le dépôt de film sur et/ou modification de la surface d'un substrat en mouvement

(43) Date of publication of application: 10.08.2016
(73) Proprietor: Coating Plasma Industrie, 13790 Peynier (FR); Vetaphone A/S, 6000 Kolding (DK)
(72) Inventor: Gat, Eric, 13790 Peynier (FR); Tran, Minh Duc, 69130 Ecully (FR); Eisby, Frank, 6000 Kolding (DK)
(74) Representative: Schmidt, Martin Peter

(56) References cited:
- US-A1- 2003 113 479

## Description

### Technical field of the invention

The invention relates to an industrial installation for the surface treatment of a moving substrate, more precisely an installation for implementing a method whereby the substrate is subjected to a plasma generated in a gaseous mixture, by which the surface is modified and/or a film is deposited onto said moving surface. The invention relates in particular to such an installation operating at a pressure close to atmospheric pressure, and that is suitable for the surface treatment of polymer films in a continuous roll-to-roll process.

### Prior art

Methods are already known for modifying and improving the properties of the surface of a substrate by means of a plasma. Such relevant properties can be for instance the surface energy and the adhesion properties of this substrate. Substrates can be insulators such as polymer films, or metal films.

According to these known methods, in order to deposit a thin solid film onto the surface of the substrate, the surface of the substrate is subjected to a plasma created by an electrical discharge in a gas and, at the same time or subsequently, the substrate thus treated is exposed to an active gaseous mixture that contains an active gaseous compound capable of causing the deposition of a thin solid film.

Methods are known in which a treatment of a substrate with electrical discharge in a gaseous mixture is performed continuously, at substrate speeds ranging from about ten to several hundred meters per minute, usually in a chamber. The chamber usually contains, in addition to the electrodes that are necessary for creating a discharge, a device for injecting the active gaseous mixture, as well as means for extracting the gaseous emissions.

WO 2004/432175 discloses a device for the treatment of a material in a plasma-assisted process. This device comprises a vacuum chamber, in which is disposed a rotating drum supporting and conveying the substrate to be treated. A plurality of independent magnetron electrodes which have rectangular magnetron fronts are arranged next to the substrate. Gas-feeding means are provided, for delivering a process gas or a process gas mixture into the space between the drum and the magnetron electrodes.

WO 2005/076918 describes a method for depositing an extremely thin barrier layer on a film, carried on a process roll in a process chamber. This is a roll to roll process carried out under vacuum. The deposition takes place in individual deposition chambers. The vacuum chamber has a common inert gas inlet.

WO 2008/042310 describes an electrode for an atmospheric corona plasma discharge. The electrode comprises a cavity for diffusing gas through a slot onto the substrate. The gas enters the cavity though a passageway and a porous body.

FR 2 816 726 A describes an installation of the above described type, comprising first a support roll against a region of which the substrate to be treated is applied. This installation also comprises electrodes housed in a chamber, which is adjacent to the support over at least the width of the substrate and along at least part of this region.

US2003113479 discloses a continuous APCVD apparatus using injection of gases parallel to the substrate. Moreover, specifically designed inlet and outlet units adjoin the chamber to oppose respectively the ingress of air into the chamber and the exit of gaseous emissions therefrom. Each unit comprises first a nitrogen-injection slit, a nitrogen introduction chamber and, downstream the slit, several grooves located near the slit. This assembly creates a zone of raised pressure in the direction of travel of the substrate, which discharges the nitrogen further upstream by forming a piston for the air stream that is to be prevented from entering. Finally, means are provided for regulating the flow rate of gas drawn out by extraction device, so as to maintain an approximately zero pressure difference between the inside of the chamber and the surrounding atmosphere.

However, the installation described in FR-A-2 816 726 has some drawbacks. First, it uses a gas knife upstream and downstream the chamber, which implies a high consumption of nitrogen. Moreover, the monitoring of the conditions inside the chamber is rather complicated; in particular, pressure inside the chamber cannot be regulated in a stable and reproducible manner. Finally, the structure of this installation is rather complicated, especially as far as the inlet and outlet units, described above, is concerned.

The objective of the present invention is to at least partially overcome these disadvantages and to propose an installation of the above type which ensures a reliable roll-to-roll surface treatment of the substrate at a pressure close to atmospheric pressure, which does not require an airtight chamber, and using a process that significantly reducing the consumption of inert gas with respect to prior art.

Another objective of the invention is to propose such an installation, which ensures a reliable surface treatment of the substrate, while being relatively easy to monitor.

Another objective of the invention is to propose such an installation, which has relatively few mechanical components, and the structure of which is simple.

Another objective of the invention is to propose such an installation, which is modular and can be quickly and easily modified to suit different types of surface treatments of the substrate.

### Subject matter

According to the invention, the problems are solved by an installation for surface-treating a moving substrate, comprising
- a housing;
- a substrate support received in said housing;
- a counter electrode;
- diffusion means for diffusing an inert gas, such as nitrogen, towards said substrate support;
- at least one head, each head comprising a top and peripheral walls, said head defining an inner volume opened opposite to said top, said head being provided with
   - at least one electrode adapted to cooperate with said counter electrode for creating an electric discharge; and with
   - injection means for injecting a gaseous mixture towards said substrate;
characterized in that
said injection means comprise at least one injection tube placed between two adjacent electrodes and/or between one electrode and a peripheral wall, said at least one injection tube being provided with injection holes facing said substrate support, for injecting said gaseous mixture on said substrate,
and in that
said diffusion means are provided inside said head, said injection tube being placed between said substrate support and said diffusion means so that, in use, said gaseous mixture is pushed against said substrate by said inert gas.

The installation according to the invention avoids the use of inlet and outlet units with nitrogen knifes, such as known from FR 2 816 726 A. Therefore, the structure of the installation according to the present invention is far less complicated, compared to this prior art. Moreover, the consumption of inert gas is greatly reduced, in particular due to the suppression of these inlet and outlet units.

Moreover the Applicant has discovered that, surprisingly, providing the diffusion means for inert gas inside the head induces no substantial loss of gaseous mixture outside the inner volume of the head. In other words, substantially the whole gaseous mixture is deposited on surfaces exposed to plasma.

Without being bound by theory, this may be due to the fact that the gaseous substance is pushed or pressed against the substrate, under the action of inert gas diffusing from the inside of the head. In addition this inert gas avoids the arrival of air, driven by the moving substrate, into the discharge zone delimited by two adjacent electrodes.

Advantageously, the housing comprises at least one means, especially at least two means, for a removable fixation of said at least one head. The installation may comprise several heads, at least one of these heads being adapted to cooperate with at least one fixation means. At least two heads, amongst these several heads, may be different.

Providing the housing with such removable fixation means brings specific advantages. First, in case of a failure of a given head, the latter may be very easily replaced by another similar head. Moreover, this head may be replaced by a different head, in order to change the nature of the treatment to which the substrate is to be submitted. The expression "different heads" means that at least one of the following parameters varies from one head to the other:
- Number of electrodes and/or tubes
- Nature of electrodes and/or tubes
- Positioning of these electrodes and tubes
- Length, i.e. dimension along the axis of the support
- Nature of the gaseous mixture connected to the tubes.

If at least two removable fixation means are provided, the installation according to the invention may have further use possibilities. Indeed, if several identical heads are mounted on the housing, a thicker deposit can be obtained without reducing the speed of the substrate. Moreover, if at least two different heads are used, the deposit may include at least two different layers.

According to one embodiment of the invention, the housing comprises opposite peripheral walls, in particular front and rear walls, and means for a removable fixation extend between said opposite peripheral walls and cooperate with side walls of said head. According to a constructive point of view, said means for a removable fixation may comprise rails extending between said opposite peripheral walls, said walls of said head being clipped between said rails.

Preferably, the installation further is adapted for maintaining an approximately zero pressure difference between the inside of the housing and the surrounding atmosphere. The expression "approximately zero" according to the present invention is to be understood as meaning a pressure difference (positive or negative) not exceeding a few tens of Pa or even 100 Pa. In particular the installation according to the invention is capable of providing plasma treatment and/or plasma deposition at atmospheric pressure.

According to other advantageous but non compulsory features of the invention:
- the installation comprises a source of said inert gas, means for flowing said inert gas from said source to each electrode, as well as means for flowing said inert gas from each electrode to said diffusion means.
- said diffusion means is placed close to said top whereas electrodes and tubes are placed close to said support.
- said head is provided with a filter dividing said head into two parts, diffusion means being placed in a first part whereas electrodes and tubes are placed in a second part.
- said tubes are elongated and both ends of each tube are fixed on brackets located close to opposite peripheral walls of the head.
- the installation comprises means for an adjustable fixation of said tubes on at least one of said brackets to permit a rotation of said tubes along their main axis.
- said means for an adjustable fixation comprise at least one clamp provided on said bracket for clipping said tube.
- each tube is provided with at least two rows of holes, two adjacent rows being offset the one towards the other.
- said electrodes are elongated and both ends of each electrode are fixed on said brackets.
- said electrodes have a square cross-section.
- the distance between injection holes of each tube and the substrate, as well as the distance between each electrode and the substrate, are adapted to permit non turbulent flow of gas.
- the installation comprises means for controlling the pressure of the inert gas diffused in the head.
- said means for controlling the pressure comprises means for controlling the flow rate of the inert gas, connected to means for measuring oxygen concentration in the vicinity of the electrodes.
- said head comprises several tubes and several electrodes arranged alternately along the travel of the substrate.
- the installation comprises means for a removable fixation of said tubes and/or said electrodes on said head.

The objectives of the invention are also achieved with an installation for surface treatment of the surface treatment of a moving substrate, such as film deposition onto and/or modification of the surface of a moving substrate, said installation comprising
- a housing;
- a substrate support received in said housing;
- a counter electrode
- at least one head, each head comprising a top and peripheral walls, said head defining an inner volume opened opposite to said top, said head being provided with
   - at least one electrode, adapted to cooperate with said counter electrode for creating an electric discharge,
   - injection means facing said substrate support, for injecting a gaseous mixture on said substrate,
   - diffusion means, for diffusing an inert gas, such as nitrogen, in the vicinity of said substrate,
wherein the housing comprises at least one means, especially at least two means, for a removable fixation of said at least one head.

The immediately above subject matter can be combined with any technically compatible feature recited in the present description, as well as recited in the appended claims.

### Description of the figures

Figure 1 is a front view, showing the installation of the invention.
Figure 2 is a perspective view, showing a housing which belongs to the installation of the invention.
Figure 3 is a perspective view, showing a head which belongs to the installation of the invention, at a greater scale, the front wall of this head being omitted.
Figure 4 is a longitudinal view, showing the head of figure 3.
Figure 5 is a longitudinal view, showing a tube which belongs to the head of figure 3.
Figures 6 and 7 are views at a larger scale, showing the details VI and VII on figure 5.
Figure 8 is a front view, showing at a still greater scale two electrodes and a tube which belong to the head of figure 3.
Figure 9 is a front view, schematically showing an installation according to a variant of the invention.
Figures 10 and 11 are schematic front views, analogous to figure 9, showing two different ways of carrying out the installation of figure 9.

Following reference numerals will be used throughout the present application:

| | | | |
|---|---|---|---|
| 7, 7', 7" | Tubes | 32 | Front wall of 30 |
| L7 | Length of 7 | 33 | Rear wall of 30 |
| D7 | Diameter of 7 | 34 | Side wall of 30 |
| R7 | Direction of rotation of 7 | 35 | Side wall of 30 |
| d7 | Distance between 7 and S | V | Inner volume of 30 |
| 8, 8', 8'' | Electrodes | G | Gap between 30 and S |
| L8 | Length of 8 | 40 | Upper part of 30 |
| W8 | Width of 8 | 42 | Diffusion means |
| d8 | Distance between 8 and S | 50 | Lower part of 30 |
| 10 | Housing | 60 | Filter |
| W10 | Width of 10 | 71 | Holes of 7 |
| L10 | Length of 10 | 72 | Holes of 7 |
| 11 | Top of 10 | L71 | Length of 71 |
| 12 | Front wall of 10 | 76 | Bracket |
| 13 | Rear wall of 10 | 78 | Clamp |
| 14 | Side wall of 10 | d78 | Distance between 7 and 8 |
| 15 | Side wall of 10 | 90 | Source of nitrogen |
| 16 | Rails | 91 | Upstream line |
| 17 | Exhaust duct | 92 | Downstream line |
| 18 | Window | 94 | Sensor |
| 19 | Door | 96 | Controller |
| 20 | Drum | 97 | Line |
| R20 | Rotation of 20 | 98 | Line |
| S | Substrate | 110 | Housing |
| 22 | Nip | 116, 116', 116" | Rails |
| 30 | Head | 120 | Drum |
| W30 | Width of 30 | 130₁-130n | Heads |
| L30 | Length of 30 | VI | Detail on figure 5 |
| 31 | Top of 30 | VII | Detail on figure 5 |

### Detailed description

The installation of the invention first comprises a body or housing 10, which has a top 11 and peripheral walls, formed by parallel front and rear walls 12 and 13, as well as parallel side walls 14 and 15. By way of example, its length L10, i.e. the distance between walls 12 and 13, is between 100 millimeters and 10 meters. By way of example, its width W10, i.e. the distance between walls 14 and 15, is between 100 millimeters and 2000 millimeters. Housing 10 is also provided with a duct 17, known as such, in view of the exhaust of excess gas out of the inner volume of this housing.

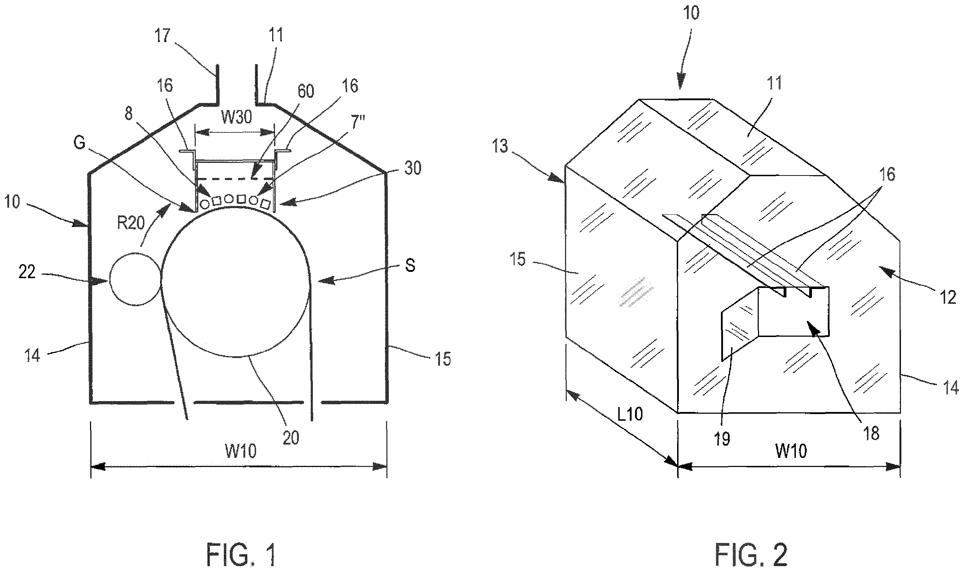

As schematically shown on figure 2, illustrating only the housing, rails 16 extend between walls 12 and 13. They are fixed on these walls with any appropriate means. The function of these rails will be described hereafter. A window 18 and a door 19 are provided on wall 12, to permit access to the rails 16.

The installation also comprises a drum 20 which rotates in use in the direction shown by the arrow R20. This drum forms a support for the substrate S to be treated. In the present embodiment, this drum also ensures a further function of counter electrode which cooperates with electrodes which will be described hereafter. However, the counter electrode may be formed by another component of the installation. By way of example, the substrate is a polymer film, whereas its thickness is between 5 micrometers and 50 millimeters.

In its upstream part, referring to the travel of the substrate, the drum is associated to a nip, or pressing roll 22, known as such. This secondary roll 22 makes it possible to press the substrate against the drum 20, so as to avoid the formation of a potential air layer between this substrate and this drum. Any local default of treatment on the substrate is therefore substantially avoided.

Above the drum 20, a cap or head 30 is arranged, which holds tubes and electrodes, as will be explained hereafter. The width W30 of the head 30 is far inferior to that W10 of the housing. This head covers part of the arc of a circle defined by the drum 20, approximately centrally.

The length L30 of this head may be slightly inferior to that L10, in particular if the substrate covers substantially the whole drum length. However, if this substrate covers only a part of this drum, the length L30 of this head may then be far inferior to L10, so that the head does not project longitudinally beyond the substrate.

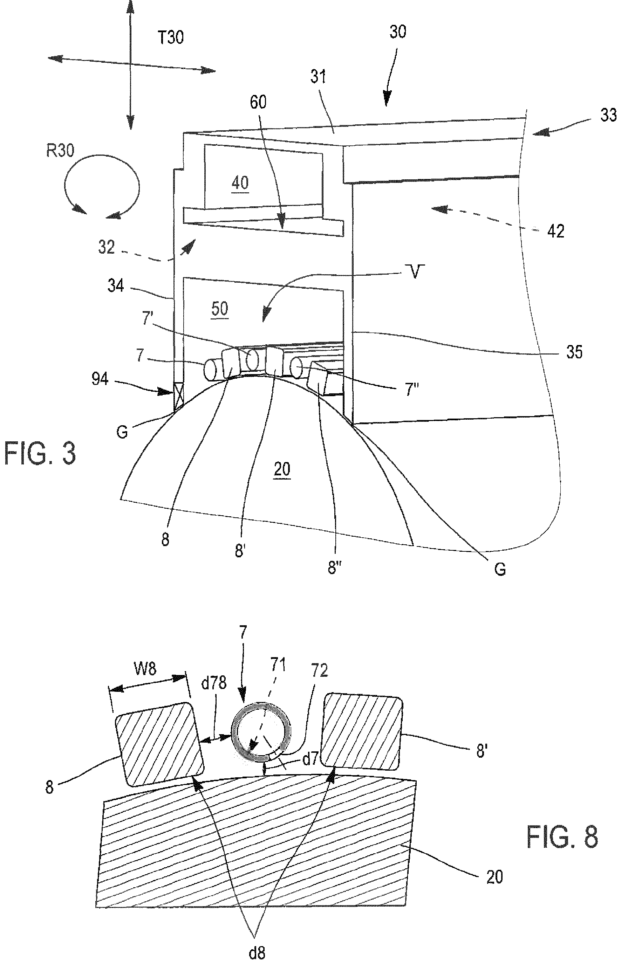

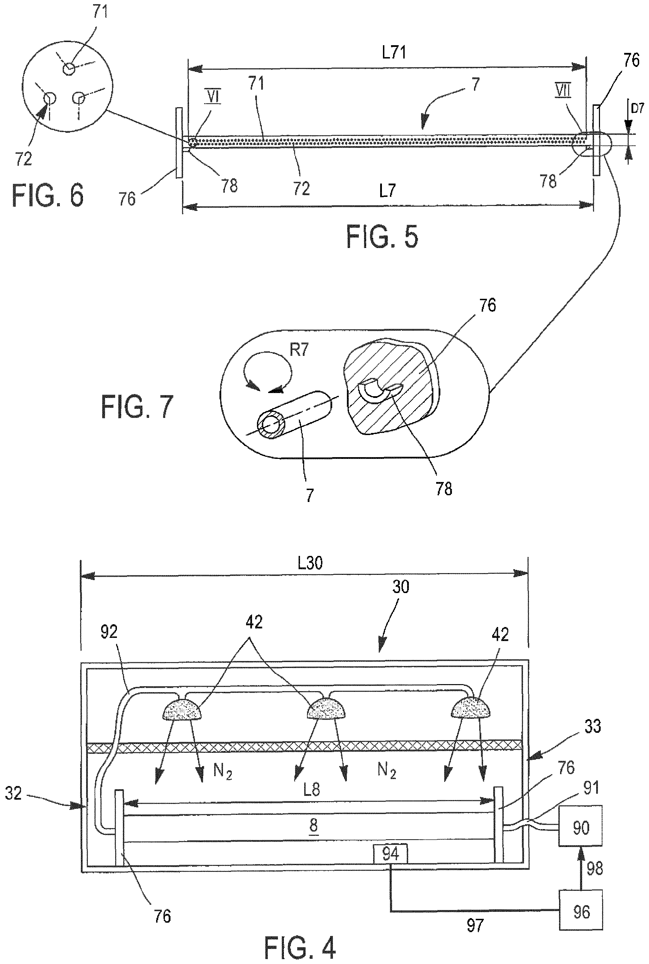

Turning to figures 3 and 4, the head 30 comprises a top 31 and peripheral walls, formed by parallel front and rear walls 32 and 33, as well as parallel side walls 34 and 35. By way of example, it is made of a non conductive material, such as PET (polyethylene terephtalate). For the sake of clarity, front wall 32 has been omitted on figure 3, whereas it is shown on figure 4.

The upper parts of side walls cooperate with above mentioned rails 16, in view of the fixation of the head. In a preferred way, this fixation makes it possible to mount head 30 on rails 16 in a removable manner, in particular by clipping.

This head 30 defines an inner volume V that is opened towards the drum 20. Each free end of these side walls and the drum 20 define two gaps G, the thickness of which may be well-defined in a way known as such. Typically this gap is between 0.5 and 2.5 millimeters. This value may be varied, by moving the head 30 relative to the support 20. This possibility is shown by arrow T30 which highlights translation movement of head 30 towards support, as well as by arrow R30, which highlights rotation movement of head.

The head is divided into two parts by a filter 60, called hereafter upper 40 and lower 50 parts. In its upper part 40, the head is provided with diffusion means, connected with a source of an inert gas such as nitrogen, as will be explained hereafter. In the illustrated example these diffusion means are formed by several diffusers 42, of any appropriate type. These diffusers, which have a multiplicity of diffusion holes, are regularly provided over the surface of the head. This filter, which is known per se, has amongst other the function of improving the homogeneity of nitrogen sent into lower part 50 of the head.

The lower part 50 of the head accomodates several tubes and electrodes. In the illustrated example, there are three tubes 7, 7' and 7", as well as three electrodes 8, 8' and 8", which extend substantially parallel the one to the other, and are arranged alternately along the direction of rotation of the drum. In other words, upstream tube 7 is disposed between side wall 34 and upstream electrode 8, whereas tubes 7' and 7" are disposed between two adjacent electrodes, namely 8, 8' and 8', 8".

According to some variants, which are not shown, the invention encompasses other relative arrangements of tubes and electrodes. By way of example, two electrodes may be placed side by side, or one tube may be disposed between downstream electrode 8" and other side wall 35. Two tubes may also be placed side by side, while being disposed between two electrodes or between a side wall and an electrode.

By way of example, the tubes are made of metal, or of plastic material, such as a polymeric material, in particular PET. They are connected to a non shown source of an active gaseous mixture, in view of carrying out a chosen treatment of the substrate S.

The structure of tube 7 will now be described, bearing in mind that other tubes 7' and 7" have the same structure. Turning to figure 5, tube 7 is elongated and has a circular shape, in cross-section. Its length L7 is slightly inferior to that L30. By way of example, it is between 100 millimeters and 10 meters. Its external diameter D7 is for example between 2 and 40 millimeters, whereas the thickness of its wall is between 0.5 and 10 millimeters.

Tube 7 is provided with two parallel rows 71 and 72 of injection holes, the manufacture of which is carried out according to any appropriate process. These holes extend over a length L71, which is a substantial part of the length of the tubes. Preferably, ratio L71/L7 is superior to 98%.

In the example, there are two rows of holes, which are offset as shown in figure 6 at a greater scale. This makes it possible to reduce the effects of injection turbulence, as well as to improve the homogeneity of the deposition. This avoids a potential deposition of an undesired film on the electrodes themselves, which would reduce the deposition speed on the substrate and would be harmful in view of the quality of this deposition.

Both ends of each tube are mounted on brackets 76, located in the vicinity respectively of front and rear walls. According to an advantageous embodiment, at least one of these ends is clipped on a clamp 78, supported by the bracket, which has the shape of a part of cylinder (see figure 7).

Therefore, this tube may be moved into rotation around its main longitudinal axis, as indicated by arrow R7, which makes it possible to vary the angle of injection of gaseous mixture towards the substrate. This makes it possible to reduce the effects of injection turbulence, as explained above.

Moreover, each tube is advantageously fixed on the head in a removable manner, either by clamping as above described, or in any analogous manner. Therefore, one tube may be easily replaced by another similar tube, in particular in case of a failure. This tube may also be replaced by a different one. The expression "different tubes" means that at least one of the following parameters varies from one tube to the other:
- Dimension of the whole tube
- Dimension of the holes
- Positioning of these holes, in particular number of rows
- Length L71 of the perforated zone.

Advantageously, each electrode has a smooth outer surface. This avoids the creation of turbulence in the plasma formation zone. This electrode is preferably made of a ceramic material, which makes it possible to treat an electrically conductive substrate. As an alternative, electrodes may also be made of any other suitable material, such as a metallic material.

The structure of electrode 8 will now be described, bearing in mind that other electrodes 8' and 8" have the same structure. Turning to figures 4 and 8, electrode 8 is elongated and has a square shape, in cross-section. Its length L8 is substantially equal to that L7 of tube 7. Its width W8 is similar to the diameter D7 of the tube 7, in particular between 10 and 20 millimeters.

Both ends of each electrode are fixed on the above brackets 76 (figure 4), in the vicinity of the ends of the tubes. Contrary to the tubes, these electrodes are not mounted on these brackets with a possibility of rotation. The electrodes 8 are connected to a source of very high voltage, which is not shown. This latest aspect is not part of the invention.

Moreover, each electrode is advantageously fixed on the head in a removable manner, thanks to any appropriate means. Therefore, one electrode may be easily replaced by another similar electrode, in particular in case of a failure. This electrode may also be replaced by a different one. The expression "different electrodes" means that at least one of the following parameters varies from one electrode to the other:
- Dimension of the whole electrode
- Material of the electrode
- Shape of the electrode.

As shown also on figure 4, electrodes 8 are connected to a common source of nitrogen, referenced as 90, via upstream lines 91. Nitrogen flows along these electrodes, then along downstream lines 92 which lead into each diffuser 42. Moreover a sensor 94, of any appropriate known type, makes it possible to measure the oxygen content in the vicinity of the electrodes. As shown in figure 3, this sensor 94 is positioned close to gap G, upstream in reference of drum rotation. This sensor is connected to a controller 96 (figure 4), via a line 97, in order to control the flow rate of nitrogen via a further line 98, which leads in source 90.

The closest distance between injection holes 71, 72 and the substrate S is referenced d7 (figure 8), whereas d8 denotes the closest distance between each electrode 8 and the substrate. Distance d8 is for example between 0.5 and 2.5 millimeters, typically between 0.5 and 1.5 millimeters, in particular equal to 1.0 millimeter. Advantageously distance d7 is slightly superior to that d8. The positioning of the head towards the counter electrode 20 may be carried out, as explained above, without any risks of contacting tubes 7 with this counter electrode. Distances d7 and d8 are chosen, so that they permit a non turbulent flow of gas in the vicinity of tubes and electrodes.

Each tube is substantially equidistant from the two electrodes, between which it is located. By way of example, the closest distance d78 (figure 8) between a tube and an electrode is between 1 and 40 millimeters, in particular between 5 and 10 millimeters. If distance d78 is too little, an electric arc may be created. Otherwise, if d78 is too high, it may create a substantial dead volume through which gaseous mixture may flow.

In use, nitrogen is first admitted into volume V via diffusers 42. The substrate is not moved, until oxygen concentration measured by sensor 94 drops under a given threshold, for example equal to 20 ppm (parts per million). When the value of this concentration is appropriate, the substrate is then moved by the support, whereas active gaseous mixture is injected via tubes 7, and discharge is created by electrodes 8. Nitrogen flowing into electrodes, via lines 91, makes it possible to evacuate heat out of these electrodes. The housing 10 is advantageously maintained at a pressure close to atmospheric pressure, during use.

Advantageously, oxygen concentration is continuously measured by sensor 94 during the purge phase with inerting gas. When this concentration exceeds the above defined threshold, the controller 90 increases the flow rate of nitrogen, to lower this oxygen concentration. This increase of flow rate induces a corresponding increase of nitrogen overpressure, into inner volume V of the head 30.

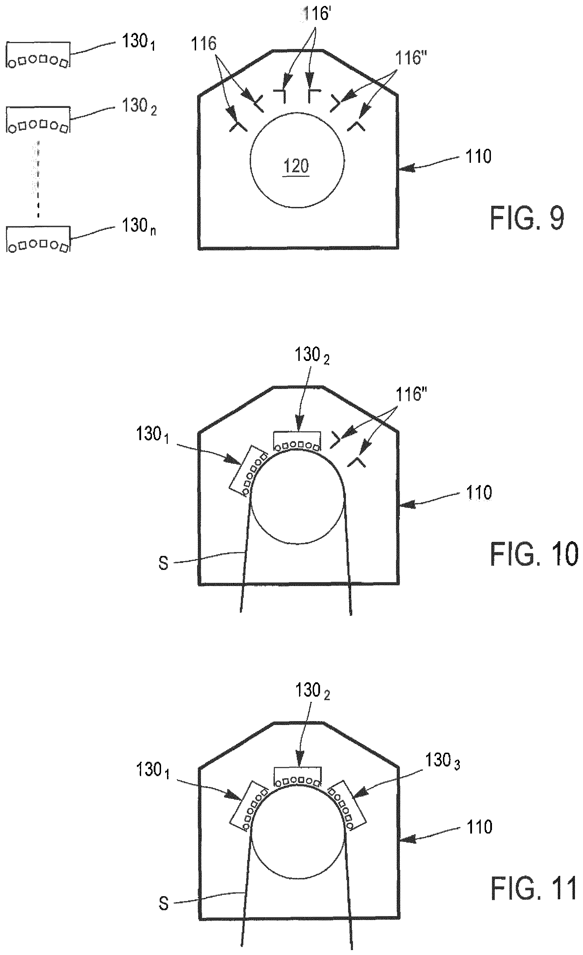

Figures 9 to 11 illustrate an alternate advantageous embodiment of the invention. Mechanical elements of these figures 9 to 11, which are similar to those of the first embodiment of figures 1 to 8, have the same reference numerals incremented with 100.

Housing 110 is provided with several pairs of rails 116, 116' and 116", which extend side by side along the travel of the substrate. In other words, there are respective upstream 116, intermediate 116' and downstream rails 116". Access to these rails is given by non shown windows and doors, as previously described. Moreover the installation comprises several heads 130₁ to 130ₙ, which may be identical or different, according to the definition given above.

According to a first non shown possibility, one single head may be positioned on any pair of rails, in particular the intermediate one 116'. A first kind of treatment of the substrate may be carried out, in the same way as described above.

Figure 10 shows another possibility in which two heads, for example 130₁ and 130₂, are placed on two pairs of rails, in particular two adjacent pairs 116 and 116'. If these heads are identical, a thick deposit can be obtained without reducing the speed of the substrate. Moreover, if these heads are different, i.e. their tubes are connected with sources of different gaseous mixtures, the deposit may include two different layers.

Figure 11 shows another further possibility in which three heads, for example 130₁, 130₂ and 130₃, are placed on the three pairs of rails. If these heads are identical, still a thicker deposit can be obtained without reducing the speed of the substrate. Moreover, if two of these heads are the same and the third one is different, the deposit may include two different layers, one of which is thicker than the other. Finally, if these heads are different, the deposit may include three different thin layers.

The installation according to the invention can be used for surface treatment of various substrates, especially films, such as metal films (for example aluminium foil) or polymer films, such as polyethylene films.

It allows efficient roll-to-roll surface treatments at industrial speed. Said surface treatment can be in one step or in two or more consecutive steps, each step being carried out with a specific head. Two and more consecutive heads can also be used to carry out the same surface treatment: multiplying the number of heads allows for instance to deposit thicker solid films without decreasing the speed of the moving substrate.

## Claims

1. Installation for surface-treating a moving substrate (S), comprising
- a housing (10; 110);
- a substrate support (20; 120) received in said housing;
- a counter electrode (20; 120);
- diffusion means (42), for diffusing an inert gas, such as nitrogen, towards said substrate support;
- at least one head (30; 130₁-130ₙ), each head comprising a top (11) and peripheral walls (12-15), said head defining an inner volume (V) opened opposite to said top, said head being provided with
- at least one electrode (8, 8', 8") adapted to cooperate with said counter electrode for creating an electric discharge; and with
- injection means (7, 7', 7") for injecting a gaseous mixture towards said substrate;
**characterized in that**
said injection means comprise at least one injection tube (7, 7', 7") placed between two adjacent electrodes (8, 8'; 8', 8") and/or between one electrode (8) and a peripheral wall (14), said at least one injection tube being provided with injection holes (71, 72) facing said substrate support, for injecting said gaseous mixture on said substrate,
and **in that**
said diffusion means (42) are provided inside said head (30), said injection tube being placed between said substrate support (20) and said diffusion means so that, in use, said gaseous mixture is pushed against said substrate by said inert gas.

2. Installation according to claim 1, **characterized in that** the housing comprises at least one means (16; 116, 116', 116"), especially at least two means (116, 116', 116"), for a removable fixation of said at least one head (30; 130₁-130ₙ).

3. Installation according to claim 2, **characterized in that** it comprises several heads (130₁-130ₙ), at least one of these heads being adapted to cooperate with at least one fixation means (16; 116, 116', 116").

4. Installation according to claim 3, **characterized in that** at least two heads, amongst these several heads, are different.

5. Installation according to any of claim 2 to 4, **characterized in that** the housing comprises opposite peripheral walls, in particular front (12) and rear (13) walls, and means (16) for a removable fixation extend between said opposite peripheral walls and cooperate with side walls of said head.

6. Installation according to one of the previous claims, **characterized in that** it comprises a source (90) of said inert gas, means (91) for flowing said inert gas from said source to each electrode (8), as well as means (92) for flowing said inert gas from each electrode to said diffusion means (42).

7. Installation according to one of the previous claims, **characterized in that** said diffusion means (42) is placed close to said top (11), whereas electrodes (8, 8', 8") and tubes (7, 7', 7") are placed close to said support (20).

8. Installation according to claim 7, **characterized in that** said head (10) is provided with a filter (60) dividing said head into two parts, diffusion means being placed in a first part (40) whereas electrodes and tubes are placed in a second part (50).

9. Installation according to one of the previous claims, **characterized in that** said tubes (7, 7', 7") are elongated and both ends of each tube are fixed on brackets (76), located close to opposite peripheral walls (14, 15) of the head.

10. Installation according to previous claim, **characterized in that** it comprises means (78) for an adjustable fixation of said tubes (7, 7', 7") on at least one of said brackets (76), to permit a rotation of said tubes along their main axis.

11. Installation according to one of claims 9 or 10, **characterized in that** said electrodes (8, 8', 8") are elongated and both ends of each electrode are fixed on said brackets (76).

12. Installation according to one of the previous claims, **characterized in that** the distance (d7) between injection holes of each tube and the substrate, as well as the distance (d8) between each electrode and the substrate, are adapted to permit non turbulent flow of gas.

13. Installation according to one of the previous claims, **characterized in that** it comprises means (96) for controlling the pressure of the inert gas diffused in the head.

14. Installation according to previous claim, **characterized in that** said means for controlling the pressure comprises means (96) for controlling the flow rate of the inert gas, connected to means (94) for measuring oxygen concentration in the vicinity of the electrodes.

15. Installation according to one of the previous claims, **characterized in that** said head (30) comprises several tubes (7, 7', 7") and several electrodes (8, 8', 8"), arranged alternately along the travel of the substrate.

## Patentansprüche

1. Installation pour traiter en surface un substrat (S) mobile, comprenant
- un logement (10 ; 110) ;
- un support de substrat (20 ; 120) reçu dans ledit logement ;
- une contre-electrode (20 ; 120) ;
- des moyens de diffusion (42), pour diffuser un gaz inerte, tel que l'azote, vers ledit support de substrat ;
- au moins une tête (30 ; 130₁ à 130ₙ), chaque tête comprenant une partie supérieure (11) et des parois périphériques (12 à 15), ladite tête définissant un volume interne (V) ouvert à l'opposé de ladite partie supérieure, ladite tête étant pourvue
- d'au moins une electrode (8, 8', 8") adaptée pour coopérer avec ladite contre-électrode afin de creer une décharge électrique ; et
- de moyens d'injection (7, 7', 7") pour injecter un melange gazeux vers ledit substrat ;
**caractérisée en ce que**
lesdits moyens d'injection comprennent au moins un tube d'injection (7, 7', 7'') placé entre deux electrodes (8, 8'; 8', 8") adjacentes et/ou entre une electrode (8) et une paroi peripheriques (14), ledit au moins un tube d'injection étant pourvu d'orifices d'injection (71, 72) se trouvant en face dudit support de substrat, pour injecter ledit mélange gazeux sur ledit substrat,
et **en ce que**
lesdits moyens de diffusion (42) sont disposes à l'intérieur de ladite tête (30), ledit tube d'injection étant placé entre ledit support de substrat (20) et lesdits moyens de diffusion de sorte que, en utilisation, ledit mélange gazeux est poussé contre ledit substrat par ledit gaz inerte.

2. Installation selon la revendication 1, **caractérisée en ce que** le logement comprend au moins un moyen (16 ; 116 ; 116', 116"), en particulier au moins deux moyens (116, 116', 116''), pour une fixation amovible de ladite au moins une tête (30 ; 130₁ ä 130ₙ).

3. Installation selon la revendication 2, **caractérisée en ce qu'**elle comprend plusieurs tetes (130₁ à 130ₙ), au moins une de ces têtes étant adaptée pour cooperer avec au moins un moyen de fixation (15 ; 116, 116', 116'').

4. Installation selon la revendication 3, **caractérisée en ce qu'**au moins deux têtes, parmi ces plusieurs têtes, sont différentes.

5. Installation selon l'une quelconque des revendications 2 à 4, **caractérisée en ce que** le logement comprend des parois péripheriques opposees, en particulier une paroi avant (12) et une paroi arrière (13), et des moyens (16) pour une fixation amovible s'etendent entre lesdites parois périphériques opposees et cooperent avec les parois laterales de ladite tête.

6. Installation selon l'une des revendications précédentes, **caractérisée en ce qu'**elle comprend une source (90) dudit gaz inerte, des moyens (91) pour l'écoulement dudit gaz inerte depuis ladite source vers chaque électrode (8), ainsi que des moyens (92) pour l'écoulement dudit gaz inerte depuis chaque électrode vers lesdits moyens de diffusion (42).

7. Installation selon l'une des revendications précédentes, **caractérisée en ce que** lesdits moyens de diffusion (42) sont placés à proximite de ladite partie superieure (11), tandis que les electrodes (8, 8', 8") et les tubes (7, 7', 7") sont placés à proximité dudit support (20).

8. Installation selon la revendication 7, **caractérisée en ce que** ladite tete (10) est pourvue d'un filtre (60) divisant ladite tête en deux parties, des moyens de diffusion étant places dans une premiere partie (40), tandis que des electrodes et des tubes sont placés dans une seconde partie (50).

9. Installation selon l'une des revendications precedentes, **caractérisée en ce que** lesdits tubes (7, 7', 7'') sont allongés et les deux extremités de chaque tube sont fixées sur des supports (76), situes à proximité des parois periphériques (14, 15) opposées de la tête.

10. Installation selon la revendication précédente, **caractérisée en ce qu'**elle comprend des moyens (78) pour une fixation ajustable desdits tubes (7, 7', 7'') sur au moins un desdits supports (76), pour permettre une rotation desdits tubes le long de leur axe principal.

11. Installation selon l'une des revendications 9 ou 10, **caractérisée en ce que** lesdites electrodes (8, 8', 8") sont allongées et les deux extremités de chaque electrode sont fixées sur lesdits supports (76).

12. Installation selon l'une des revendications précédentes, **caractérisée en ce que** la distance (d7) entre les orifices d'injection de chaque tube et le substrat, ainsi que la distance (d8) entre chaque électrode et le substrat, sont adaptees pour permettre un écoulement non turbulent du gaz.

13. Installation selon l'une des revendications précédentes, **caractérisée en ce qu'**elle comprend des moyens (96) pour réguler la pression du gaz inerte diffuse dans la tête.

14. Installation selon la revendication précédente, **caracterisee en ce que** lesdits moyens pour réguler la pression comprennent des moyens (96) pour régler le débit du gaz inerte, raccordé ä des moyens (94) pour mesurer la concentration en oxygène au voisinage des électrodes.

15. Installation selon l'une des revendications précedentes, **caractérisée en ce que** ladite tête (30) comprend plusieurs tubes (7, 7', 7'') et plusieurs electrodes (8, 8', 8''), agences en alternance le long du trajet du substrat.

## Revendications

1. Anlage für die Oberflächenbehandlung eines sich bewegenden Substrats (S), umfassend
- ein Gehäuse (10; 110);
- einen Substratträger (20; 120), der in dem Gehâuse aufgenommen ist;
- eine Gegenelektrode (20; 120);
- Diffusionsmittel (42) zum diffundieren eines inerten Gases, wie z.B. Stickstoff, zu dem Substratträger hin;
- wenigstens einen Kopf (30; 130₁ bis 130ₙ), wobei jeder Kopf eine Oberseite (11) und periphere Wânde (12 bis 15) umfasst, wobei der Kopf ein Innenvolumen (V) definiert, das gegenüber der Oberseite geoffnet ist, wobei der Kopf mit
- wenigstens einer Elektrode (8, 8', 8''), die derart angepasst ist, um mit der Gegenelektrode zum Erzeugen einer elektrischen Entladung zu kooperieren; und mit
- Einspritzmitteln (7, 7', 7'') zum Einspritzen einer gashaltigen Mischung zum Substrat hin bereitgestellt ist; **dadurch gekennzeichnet, dass**
die Einspritzmittel wenigstens ein Einspritzrohr (7, 7', 7") umfassen, das zwischen zwei benachbarten Elektroden (8, 8'; 8', 8'') und/oder zwischen einer Elektrode (8) und einer peripheren Wand (14) platziert ist, wobei das wenigstens eine Einspritzrohr mit Einspritzöffnungen (71, 72) bereitgestellt ist, die dem Substratträger gegenüberliegen, um die gashaltige Mischung auf das Substrat aufzuspritzen,
und dass
die Diffusionsmittel (42) im Inneren des Kopfes (30) bereitgestellt sind, wobei das Einspritzrohr zwischen dem Substratträger (20) und den Diffusionsmitteln derart platziert ist, dass während dem Gebrauch die gashaltige Mischung durch das inerte Gas gegen das Substrat gedrückt wird.

2. Anlage nach Anspruch 1, **dadurch gekennzeichnet, dass** das Gehäuse wenigstens ein Mittel (16; 116, 116', 116''), insbesondere wenigstens zwei Mittel (116, 116', 116") für eine entfernbare Fixierung des wenigstens einen Kopfes (30; 130₁-130ₙ) umfasst.

3. Anlage nach Anspruch 2, **dadurch gekennzeichnet, dass** sie mehrere Köpfe (130₁ bis 130ₙ) umfasst, wobei wenigstens einer dieser Köpfe derart angepasst ist, um mit wenigstens einem Fixierungsmittel (16; 116, 116', 116'') zu kooperieren.

4. Anlage nach Anspruch 3, **dadurch gekennzeichnet, dass** unter diesen mehreren Köpfen wenigstens zwei Köpfe verschieden sind.

5. Anlage nach einem der Ansprüche 2 bis 4, **dadurch gekennzeichnet, dass** das Gehâuse gegenüberliegende periphere Wände, insbesondere vordere (12) und rückwärtige (13) Wände umfasst, und Mittel (16) für eine entfernbare Fixierung sich zwischen den gegenüberliegenden peripheren Wänden erstrecken und mit den Seitenwänden des Kopfes kooperieren.

6. Anlage nach einem der vorstehenden Ansprüche, **dadurch gekennzeichnet, dass** sie eine Quelle (90) des inerten Gases, Mittel (91) zum Strömen des inerten Gases von der Quelle zu jeder Elektrode (8) sowohl als Mittel (92) zum Strömen des inerten Gases von jeder Elektrode zu den Diffusionsmitteln (42) umfasst.

7. Anlage nach einem der vorstehenden Ansprüche, **dadurch gekennzeichnet, dass** die Diffusionsmittel (42) in der Nähe der Oberseite (11) platziert sind, während die Elektroden (8, 8', 8") und Rohre (7, 7', 7") in der Nähe des Trâgers (20) platziert sind.

8. Anlage nach Anspruch 7, **dadurch gekennzeichnet, dass** der Kopf (10) mit einem Filter (60) bereitgestellt ist, der den Kopf in zwei Teile teilt, wobei Diffusionsmittel in einem ersten Teil (40) platziert sind, während die Elektroden und Rohre in einem zweiten Teil (50) platziert sind.

9. Anlage nach einem der vorstehenden Ansprüche **dadurch gekennzeichnet, dass** die Rohre (7, 7', 7") verlängert sind und beide Ende jedes Rohrs an Halterungen (76) fixiert sind, die sich in der Nâhe der gegenüberliegenden peripheren Wände (14, 15) des Kopfes befinden.

10. Anlage nach dem vorstehenden Anspruch, **dadurch gekennzeichnet, dass** sie Mittel (78) für eine verstellbare Fixierung der Rohre (7, 7', 7") an wenigstens einer der Halterungen (76) umfasst, um eine Umdrehung der Rohre entlang ihrer Hauptachse zu erlauben.

11. Anlage nach einem der Ansprüche 9 oder 10, **dadurch gekennzeichnet, dass** die Elektroden (8, 8', 8'') verlängert sind und beide Enden jeder Elektrode an den Halterungen (76) fixiert sind.

12. Anlage nach einem der vorstehenden Ansprüche, **dadurch gekennzeichnet, dass** der Abstand (d7) zwischen den Einspritzöffnungen jedes Rohrs und dem Substrat sowohl als auch der Abstand (d8) zwischen jeder Elektrode und dem Substrat jeweils derart angepasst sind, um eine nicht wirbelige Strömung von Gas zu erlauben.

13. Anlage nach einem der vorstehenden Ansprüche, **dadurch gekennzeichnet, dass** sie Mittel (96) zur Steuerung des Drucks des inerten Gases, das in dem Kopf diffundiert wird, umfasst.

14. Anlage nach dem vorstehenden Anspruch, **dadurch gekennzeichnet, dass** die Mittel zur Steuerung des Drucks Mittel (96) zur Steuerung der Strömungsrate des inerten Gases umfassen, die an Mittel (94) zum Messen der Sauerstoffkonzentration in der Nähe der Elektroden angeschlossen sind.

15. Anlage nach einem der vorstehenden Ansprüche, **dadurch gekennzeichnet, dass** der Kopf (30) mehrere Rohre (7, 7', 7') und mehrere Elektroden (8, 8', 8'') umfasst, die abwechselnd entlang des Wegs des Substrats angeordnet sind.
